**Europäisches Patentamt**

**European Patent Office**

**Office européen des brevets**

(19)

(11)  **EP 1 085 566 A1**

(12) ## EUROPEAN PATENT APPLICATION

(43) Date of publication:
**21.03.2001 Bulletin 2001/12**

(51) Int Cl.⁷: **H01L 21/56**, H01L 23/31

(21) Application number: **99810829.4**

(22) Date of filing: **16.09.1999**

(84) Designated Contracting States:
**AT BE CH CY DE DK ES FI FR GB GR IE IT LI LU MC NL PT SE**
Designated Extension States:
**AL LT LV MK RO SI**

(71) Applicant: **"3P" LICENSING B.V.
NL-6902 PA Zevenaar (NL)**

(72) Inventor: **De Kok, Johannes Marinus Maria, Dr.
4617 NW Bergen op Zoom (NL)**

(74) Representative: **Bakkum, Ruben Joseph
van Exter Polak & Charlouis B.V.,
P.O. Box 3241
2280 GE Rijswijk (NL)**

(54)  **Method and apparatus for partially encapsulating semiconductor chips**

(57)    A method for partially encapsulating a semiconductor chip (1) mounted on a substrate (2) is disclosed, wherein

- the substrate (2) is placed on a first mold halve (4) of a mold,

- a film (7) is placed between the semiconductor chip (1) and a second mold halve (5),
- the film (7) is pressed against the semiconductor chip (1), and
- encapsulating material (21) is injected into the mold.

Fig. 2

**Description**

The invention concerns a method and an apparatus for encapsulating semiconductor chips in accordance with the preamble of claim 1 or 6, respectively.

Transfer molding is a widely used, cheap and reliable process to encapsulate semiconductor chips. The semiconductor chips are mounted on a substrate and the substrate is placed in a cavity of a mold. Then the substrate is firmly clamped between the edges of the two mold halves forming the cavity in order to seal the cavity and to prevent leakage while the encapsulating material is injected into the cavity with high pressure.

So far transfer molding has not been used to encapsulate semiconductor chips if at least a part of the chip's surface must remain free of encapsulating material. In such cases glob tops are dispensed at the desired positions of the semiconductor chip. With flip chips the space between the chip and the substrate is usually filled with a so-called underfill material which typically is a thermoset of low viscosity which is brought into the space between the chip and the substrate by capillary suction. The process time for all these techniques is relatively long, because the flow-rate of the material cannot be increased to high values by applying injection/transfer pressure. Additionally, the reliability of the final product is low, since a cure pressure cannot be applied to compress the encapsulating material under such process conditions. Alternatives, such as injection molding or transfer molding, are not possible, because these processes require sealing of the filling volume. This requires firm clamping on the bare chips, but no techniques are available at present to seal the fragile semiconductor chips without damaging.

The object of the invention is to develop a fast and reliable process for molding semiconductor chips having at least a part of their surface free of encapsulating material.

This object is solved by means of a molding process according to claim 1.

The invention proposes to place a relatively soft film between the clamping edge of a clamping tool and the semiconductor chip. The film damps and smoothes the stress concentrations and thus cracks in the semiconductor chip are avoided. Preferably the edges of the clamping tool have rounded corners.

The pressure exerted by the clamping tool on the semiconductor chip must on the one hand side be high enough in order to sufficiently seal and to avoid bleeding and must on the other hand be small enough to avoid damaging the semiconductor chip. Variations in the height of the semiconductor chip may be compensated to a certain degree by the compressable film. Variations in the height of the semiconductor chip may be compensated even more if the clamping tool is spring mounted.

The invention specifically discloses a method for partially encapsulating a semiconductor chip mounted on a substrate, wherein

- the substrate is placed on a first mold halve of a mold,
- a film is placed between the semiconductor chip and a second mold halve,
- the film is pressed against the semiconductor chip, and
- encapsulating material is injected into the mold,

and an apparatus suitable for applying the method.

The invention is described below in greater detail, by reference to and in conjunction with the drawings, in connection with a typical embodiment of a molding apparatus. The drawings are not to scale. It is shown in:

Fig. 1     a first molding apparatus,
Fig. 2     a second molding apparatus,
Fig. 3     a clamping surface,
Fig. 4     a third molding apparatus,
Fig. 5     another clamping surface, and
Fig. 6     a molded semiconductor chip with a bare surface.

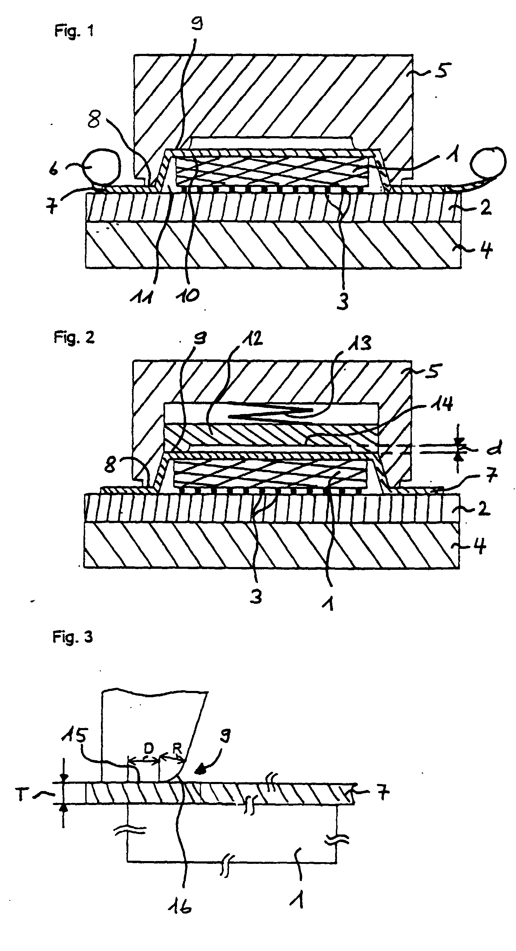

Fig. 1 shows a molding apparatus suitable for filling the space between a semiconductor chip 1 and a substrate 2 onto which the semiconductor chip 1 is mounted as flip chip by a transfer molding process. The semiconductor chip 1 and the substrate 2 are connected through a number of bumps 3. The molding apparatus comprises two mold halves 4 and 5 and a film handler 6 providing a film 7. The substrate 2 carrying the semiconductor chip 1 is placed on the upper surface of the first mold halve 4. A piece of film 7 has been drawn over the flipped semiconductor chip 1 and the substrate 2. The second mold halve 5 is designed in such a way that a first clamping face 8 presses the film 7 against the substrate 2 and a second clamping face 9 presses the film 7 against selected areas of the upper surface 10 of the semiconductor chip 1. Thus a sealed cavity 11 is formed between the film 7 and the substrate 2. The clamping face 8 of the second mold halve 5 is provided with an injection channel (not shown) which connects the cavity 11 with a pot of the molding apparatus so that the encapsulating material can be injected into the cavity 11 and compressed with a standard transfer molding process. Thus the space between a flip chip and its substrate can be filled with underfill material with a cheap and reliable process.

The film 7 smoothes the stress induced in the semiconductor chip 1 and therefore reduces stress concentrations while clamping the two mold halves 4 and 5 together. The film 7 also perfectly seals the cavity 11.

Fig. 2 shows another molding apparatus where the clamping face 9 is part of a separate clamping tool 12 which is resiliently mounted in the second mold halve 5, e.g. by means of a spring 13. This embodiment decouples the pressures exerted on the substrate 2 and on the semiconductor chip 1.

Preferably the clamping tool 12 is gimbal mounted so that it is tiltable in all directions and can adapt itself to the orientation of the upper surface 10 of the semiconductor chip 1. Preferably the clamping tool 12 is designed in such a way that the middle portion 14 inside the circumferential edges with the clamping faces 9 is recessed only by a small distance d of some micrometers. This prevents bending the semiconductor chip 1 too much and limits the stresses induced in the bumps 3 during the last phase of transfer molding when the cure pressure is applied to compress and harden the encapsulating material. Of course if the distance d is smaller than the distance the film 7 is impressed at the location of the clamping face 9 then the middle portion 14 also acts as a third clamping face.

Fig. 3 shows in more detail the contour of the clamping face 9 in relation to the position of the semiconductor chip 1. The clamping face 9 has a flat part 15 which extends parallel to the upper surface 10 of the semiconductor chip 1 and a rounded corner 16 with radius R. Preferably the radius R of the corner 16 lies within the range of $0.2T < R < 5T$ wherein T denotes the thickness of the film 7. The distance D representing the overlap between the flat part 15 of the clamping face 9 and the upper surface 10 of the semiconductor chip 1 preferably meets the conditions $T < D < 3T$. If the radius R of the corner 16 is small compared to the thickness T of the film 7, then the pressure area of the clamping face 9 is about $(D+R) * U$, where U denotes the circumference of the clamping face 9.

Such a film 7 is a relatively soft material which when set under pressure in one direction flows in the other directions. This means that upon applying the clamping pressure to the film 7, film material will flow out horizontally. The thicker the film 7 the more film material flows out. Therefore the thickness of the film 7 must not be too high. A suitable film material is ETFE (film of polytetrafluorethylene modified with ehtylene) and suitable film thicknesses are about 25 to 200 μm, preferably about 50 to 100 μm.

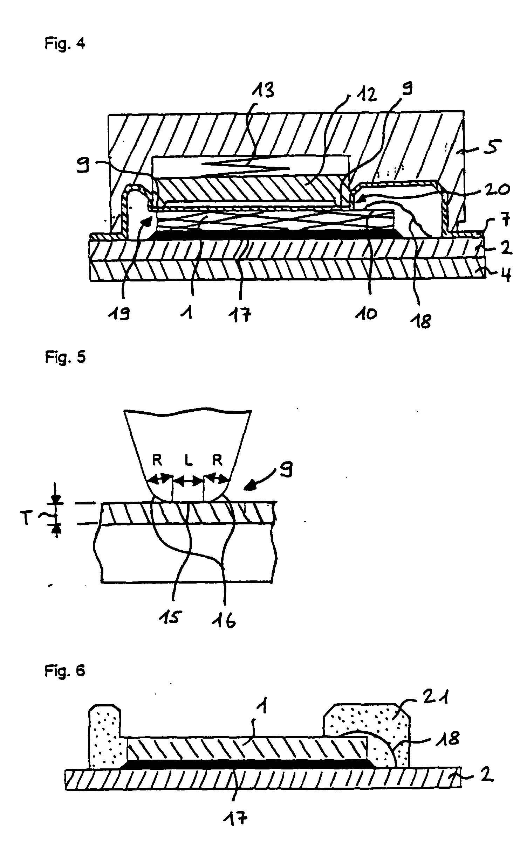

Fig. 4 shows another molding apparatus suitable for encapsulating semiconductor chips 1 with transfer molding where only a part of the upper surface 10 of the semiconductor chip 1 is to be encapsulated. The surface of the second mold halve 5 is formed according to the desired final shape of the molded device. Optionally it is provided with a number of suction holes in order to attach the film 7 by means of vacuum. The semiconductor chip 1 is mounted on the substrate 2 with an adhesive 17. Wires 18 electrically connect the semiconductor chip 1 with the substrate 2. The second mold halve 5 is again provided with the spring 13 loaded clamping tool 12.

The left edge 19 of the clamping tool 12 has a clamping face 9 as described with reference to fig. 3. The right edge 20 (Fig. 4) of the clamping tool 12 has a clamping face 9 as shown in fig. 5. Two rounded corners 16 of radius R limit the flat part 15. Preferably the radius R of the corners 16 meets the conditions $0.2T < R < ST$ whereas the distance L characterizing the length of the flat surface 15 preferably meets the conditions $T < L < 3T$. The shape of the rounded corners 16 may be circular or parabolic or may have any other curved form.

Fig. 6 shows the molded device. The encapsulating material is denoted with reference numeral 21.

Although it is preferred that the film 7 covers both the semiconductor chip 1 and the substrate 2 it is not absolutely necessary that the film 7 covers the substrate 2. It is sufficient if the film 7 covers the semiconductor chip 1 beneath the clamping face 9.

With an apparatus as shown in fig. 1 the film 7 can already compensate for substantial variations in height of the semiconductor chips 1 while on the one hand maintaining sufficient clamping pressure to avoid bleed and on the other hand avoiding to damage the semiconductor chip 1. However, spring loading the clamping tool 12, as disclosed with apparatuses shown in figs. 2 and 4, increases the maximum variations in height of the semiconductor chip 1 that can be compensated. Such apparatuses are therefore used when the thickness T of the film 7 is smaller than the desired maximum variations in height of the semiconductor chips 1 or when the stiffness of the film 7 is too high.

The total stiffness $S_{tot}$ of the resilient system consisting of the film 7 with stiffness $S_{film}$ and of the spring 13 with stiffness $S_{spring}$ must be chosen such that the maximum possible pressure does not damage the semiconductor chip 1. The total stiffness $S_{tot}$ must meet the condition

$$S_{total} = \frac{1}{\dfrac{1}{S_{spring}} + \dfrac{1}{S_{film}}} \leq A_{surface} \frac{P_{max} - P_{min}}{\Delta Z} \tag{1}$$

where

- $\Delta z$ denotes the desired maximum variations in height of the semiconductor chips 1,
- $A_{surface}$ denotes the total area of the clamping face 9 touching the semiconductor chip 1,
- $P_{min}$ denotes the minimum pressure that is necessary to efficiently seal the semiconductor chip 1, and
- $P_{max}$ denotes the maximum pressure that is allowed without damaging the semiconductor chip 1.

From this equation the stiffness $S_{spring}$ of the spring 13 can be calculated to

$$S_{spring} < \frac{A_{surface}}{\dfrac{\Delta Z}{P_{max} - P_{min}} - \dfrac{T}{E_{film}}} \qquad (2)$$

where $E_{film}$ and T denote the elasticity modulus and the thickness of the film 7, respectively.

Example

The example concerns a relatively large semiconductor chip 1 of 13.5 mm by 23.0 mm as shown in fig. 4 which needs a large unmolded area of 12.0mm by 18.5mm. One side (right side in fig. 4) of the semiconductor chip 1 needs to be overmoulded to cover the wires 18, while the other side (left side in fig. 4) is preferred not to be overmoulded on the edges. All the corners 16 of the clamping face 9 have a radius R of 0.1 mm. The distance L (see fig. 5) of the flat part 15 between the two corners 16 of the right edge 20 of the clamping tool 12 is 0.1 mm whereas the distance D (see fig. 3) of the flat part 15 of the left edge 19 of the clamping tool 12 where the chip-edge is not to be encapsulated is 0.2 mm. This yields a total surface of the clamping surface $A_{surface}$ of about 17.94 mm2.

No damage at the semiconductor chips 1 had been observed when applying a pressure of $P_{max}$ = 27.9 MPa when using this clamping tool 12 together with an ETFE-film having a thickness T of 100 µm and an elasticity modul $E_{film}$ of 45 MPa. The maximum pressure inside the cavity 11 was designed to be 10 MPa. The minimum pressure $P_{min}$ of the clamping tool 12 must of course be bigger than the maximum molding pressure, which implies that for this example $P_{min}$ = 10MPa.

From equation 1 it can be derived that the above ETFE-film alone would be able to compensate for 39.8 µm in variation of the height of the semiconductor chip 1. However, as a maximum variation of 100 µm is required the clamping tool 12 must be arranged resiliently as shown in fig. 4. From equation 2 the stiffness $S_{spring}$ of the spring 13 can be calculated to be less than 5.3N/µm. Using a disc spring having a stiffness $S_{spring}$ of 2.2N/µm even a maximum variation in chip-height of 183 µm would have been allowed. With the practically expected variation in chip height of 100 µm, the maximum pressure to expect is only 19.8 MPa.

**Claims**

1.   Method for partially encapsulating a semiconductor chip (1) mounted on a substrate (2), wherein

-   the substrate (2) is placed in a first mold halve (4) of a mold,
-   a film (7) is placed between the semiconductor chip (1) and a second mold halve (5),
-   the film (7) is pressed against the semiconductor chip (1), and
-   encapsulating material (21) is injected into the mold.

2.   Method according to claim 1, wherein the film (7) is pressed against the semiconductor chip (1) by means of a resiliently mounted clamping tool (12).

3.   Method according to claim 2, wherein the clamping tool (12) is tiltable in all directions.

4.   Method according to one of claims 1 to 3, wherein the film (7) is pressed against the semiconductor chip (1) by means of a clamping face (9) with rounded corners (16).

5.   Method according to one of claims 1 to 4, wherein bending of the semiconductor chip (1) is limited.

6.   Apparatus for partially encapsulating a semiconductor chip (1) mounted on a substrate (2), comprising two mold halves (4, 5), the first mold halve (4) receiving the substrate (2) with the semiconductor chip (1), and a film handler (6) for placing a film (7) between the semiconductor chip (1) and the second mold halve (5), the second mold halve (5) comprising a clamping face (9) for pressing the film (7) against the semiconductor chip (1).

7. Apparatus according to claim 6, wherein the clamping face (9) is part of a clamping tool (12) that is resiliently mounted in the second mold halve (5).

8. Apparatus according to claim 6 or 7, wherein the clamping face (9) borders a recessed portion (14) limiting the bending of the semiconductor chip (1).

9. Apparatus according to one of claims 6 to 8, wherein the clamping face (9) has rounded comers (16).

10. Apparatus according to one of claims 6 to 9, wherein the clamping tool (12) is tiltable in all directions.

Fig. 1

Fig. 2

Fig. 3

Fig. 4

Fig. 5

Fig. 6

**European Patent Office**

## EUROPEAN SEARCH REPORT

Application Number

EP 99 81 0829

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | EP 0 637 196 A (SANDEROV VILYAM LAZAREVICH ;TSAREV VIKTOR NIKOLAEVICH (RU); DYAKOV) 1 February 1995 (1995-02-01) * column 1, line 53 - column 7, line 5; figures 2-7 * --- | 1-10 | H01L21/56 H01L23/31 |
| A | EP 0 795 901 A (TOWA CORP) 17 September 1997 (1997-09-17) * column 10, line 17 - column 13, line 27; figures 3,4 * --- | 1-10 | |
| A | WO 97 33312 A (TESSERA INC) 12 September 1997 (1997-09-12) * abstract; figure 1 * ----- | 1,6 | |

| | | | TECHNICAL FIELDS SEARCHED (Int.Cl.7) |
|---|---|---|---|
| | | | H01L |

The present search report has been drawn up for all claims

| Place of search | Date of completion of the search | Examiner |
|---|---|---|
| BERLIN | 20 January 2000 | Munnix, S |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**                    EP 99 81 0829

This annex lists the patent family members relating to the patent documents cited in the above-mentioned European search report.
The members are as contained in the European Patent Office EDP file on
The European Patent Office is in no way liable for these particulars which are merely given for the purpose of information.

20-01-2000

| Patent document cited in search report | | Publication date | Patent family member(s) | | Publication date |
|---|---|---|---|---|---|
| EP 0637196 | A | 01-02-1995 | WO | 9416544 A | 21-07-1994 |
| EP 0795901 | A | 17-09-1997 | JP | 9252018 A | 22-09-1997 |
| | | | JP | 10189630 A | 21-07-1998 |
| | | | SG | 50009 A | 15-06-1998 |
| | | | US | 5874324 A | 23-02-1999 |
| WO 9733312 | A | 12-09-1997 | US | 5834339 A | 10-11-1998 |
| | | | US | 5776796 A | 07-07-1998 |
| | | | AU | 2063097 A | 22-09-1998 |

EPO FORM P0459

For more details about this annex : see Official Journal of the European Patent Office, No. 12/82